Europäisches Patentamt

European Patent Office

Office européen des brevets

(19)

(11) Veröffentlichungsnummer: **O OO3 213**
**B1**

(12) **EUROPÄISCHE PATENTSCHRIFT**

(45) Veröffentlichungstag der Patentschrift: **26.10.83**

(51) Int. Cl.³: **H O1 L 31/00, H O4 N 3/14**

(21) Anmeldenummer: **78101415.4**

(22) Anmeldetag: **20.11.78**

(54) Optoelektronischer Sensor nach dem Prinzip der Ladungsinjektion und Verfahren zu seiner Herstellung.

(30) Priorität: **07.12.77 DE 2754549**

(43) Veröffentlichungstag der Anmeldung:
**08.08.79 Patentblatt 79/16**

(45) Bekanntmachung des Hinweises auf die Patenterteilung:
**26.10.83 Patentblatt 83/43**

(84) Benannte Vertragsstaaten:
**BE DE FR GB NL**

(56) Entgegenhaltungen:
**DE - A - 2 554 638**
**DE - A - 2 703 877**
**DE - A - 2 723 933**
**US - A - 3 950 188**
**US - A - 3 988 613**
**US - A - 3 995 302**
**US - A - 4 024 562**

**IBM Technical Disclosure Bulletin, Vol. 18, No. 8, January 1976, Armonk, N.Y., R. H. DENNARD et al. "Controllable process for fabricating short-channel FET device"**

(73) Patentinhaber: **SIEMENS AKTIENGESELLSCHAFT Berlin und München Wittelsbacherplatz 2 D-8000 München 2 (DE)**

(72) Erfinder: **Herbst, Heiner**
**Am See 2**
**D-8013 Haar (DE)**
Erfinder: **Koch, Rudolf**
**Nimrodstrasse 42**
**D-8034 Germering-Unterpfaffenhofen (DE)**
Erfinder: **Pfleiderer, Hans-Jörg**
**Franz-Krinninger Weg 23**
**D-8011 Zorneding (DE)**
Erfinder: **Tihanyi, Jenö**
**Wolfratshauser Strasse 179b**
**D-8000 München 71 (DE)**

## Optoelektronischer Sensor nach dem Prinzip der Ladungsinjektion und Verfahren zu seiner Herstellung

Die Erfindung betrifft einen optoelektronischen Sensor mit mindestens einem Sensorelement nach dem Prinzip der Ladungsinjektion. Dabei stehen der Oberfläche eines dotierten Halbleiterkörpers zwei eng benachbarte, gegeneinander und gegenüber der Halbleiteroberfläche durch eine dünne Isolierschicht isolierte, über getrennte Steuerleitungen ansteuerbare Elektroden gegenüber (sog. CID-Sensor).

Bei der elektronischen Erfassung von Bildern nach dem Prinzip der Ladungsinjektion wird an einen Kondensator, der aus einen Halbleiterkörper und einer von der Halbleiteroberfläche durch eine Isolierschicht getrennten Metallelektrode besteht (MIS-Kondensator), mittels elektrischer Anschlüsse für den Halbleiterkörper und die Metallelektrode eine derartige Spannung gelegt, daß die im Halbleiter befindlichen Majoritätsträger vom Substrat abgezogen werden und unter der Metallelektrode eine Verarmungsschicht entsteht, in der die während der Bestrahlungszeit optisch erzeugten Minoritätsträger gesammelt werden. Durch eine Spannungsänderung an der Metallelektrode können die gesammelten optisch erzeugten Ladungsträger anschließend in das Substrat injiziert und von dort ausgelesen werden.

Um ein Bild rasterförmig durch mehrere Bildpunkte erfassen zu können, werden auf der Halbleiteroberfläche entsprechende Sensorelemente angeordnet, die jeweils von einem Paar kapazitiv miteinander gekoppelter, derartiger MIS-Kondensatoren gebildet werden und in deren Verarmungsschichten während der Belichtungszeit die optisch erzeugten Minoritätsträger gesammelt werden. Zum Auslesen des in einem Sensorelement gesammelten Signals wird häufig die eine Metallelektrode eines Elements elektrisch frei schwebend gehalten (sog. "floaten"), während das Potential der anderen Elektrode betragsmäßig verringert wird. Dadurch fließt die Signalladung von der zweiten Elektrode auf den MIS-Kondensator der ersten Elektrode und erzeugt dort ein Signal, das der Menge der optisch erzeugten Ladungen und somit der Intensität des eingestrahlen Lichtes entspricht. Anschließend wird durch einen Spannungsimpuls an der ersten Elektrode die gesammelte Ladung ins Substrat injiziert und der Sensor in den entleerten Ausgangszustand für die nächste Belichtung versetzt.

Zur Erfassung ausgedehnter Bilder werden dabei häufig Halbleiterkörper verwendet, auf deren Oberfläche die Sensorelemente rasterförmig in Spalten und Zeilen angeordnet sind und jeweils die eine Elektrode jedes Elementes über eine Zeilenleitung mit den einen Elektroden der in der gleichen Zeile angeordneten Elemente verbunden sind, während die andere Elektrode jedes Sensorelementes über eine entsprechende Spaltenleitung mit den anderen Elektroden der in der gleichen Spalte stehenden Sensorelemente verbunden sind. Werden alle während der Belichtungszeit zunächst auf einer Betriebsspannung liegenden Spaltenleitung von der Spannungsquelle getrennt, so daß sie elektrisch frei schweben, und wird nun über ein Schieberegister eine bestimmte Zeilenelektrode ausgewählt, deren Spannung betragsmäßig verringert wird, so ändert sich das Potential an den Spaltenleitungen durch die kapazitive Kopplung entsprechend der aufgenommenen Inversionsladung und kann als Signal entnommen werden, das der in den jeweiligen Kreuzungspunkten der Spaltenleitungen mit der ausgewählten Zeilenleitung gesammelten optisch erzeugten Ladung entspricht.

Die kapazitive Kopplung zwischen den beiden Elektroden eines Elementes bewirkt jedoch, daß bei der Verringerung des Potentials an der ausgewählten Zeilenleitung, d.h. beim Verschieben der Ladung unter die Spaltenelektrode, das Signal an der freischwebenden Spaltenleitung von Einkopplungen der Zeilenspannung überlagert wird. Diese kapazitiven Einkopplungen entstehen sowohl, wenn zu Beginn der Ladungsverschiebung das Potential der Zeilenleitung verringert wird und, mit umgekehrten Vorzeichen, wenn am Ende der Ladungsverschiebung die Spaltenleitung wieder auf das Ausgangssignal zurückgesetzt wird. Durch entsprechende Integration über beide Impulsflanken können derartige Einkopplungen wenigstens teilweise eliminiert werden. Jede Ungleichmäßigkeit der Einkopplungen untereinander verfälscht jedoch das Signal.

Der Erfindung liegt die Aufgabe zugrunde, einen möglichst einfach herzustellenden CID-Sensor anzugeben, bei dem sich die kapazitiven Einkopplungen möglichst vollständig kompensieren.

Dies wird gemäß der Erfindung dadurch erreicht, daß bei einem Sensor der eingangs angegebenen Art der Halbleiterkörper an seiner Oberfläche unter der einen Elektrode jedes Sensorelementes ein stärker dotietes Gebiet vom Typ der Halbleiterdotierung enthält, das sich geringfügig in die unter der anderen Elektrode liegende Halbleiteroberfläche hinein erstreckt.

Bei einem zweidimensionalen Sensor mit rasterförmig in Spalten und Zeilen angeordneten Sensorelementen wird durch die Reduzierung des Potentials der ausgewählten Zeilenleitung die Signalladung auf die Spaltenkondensatoren geschoben. Gleichzeitig damit erfolgt die Takteinkopplung von der Zeilenleitung auf die Spaltenleitung. Im Spaltenkondensator wird demnach die Ladung $Q_{Signal} + Q_{Takt}$ gespeichert. Kann man nun das Potential der Zeilenleitung auf den ursprünglichen Wert zurücksetzen, ohne daß die Ladung gleichzeitig in den Zeilenkondensator zurückfließt, so wird die Ladung im Spaltenkondensator um die kapazitiv eingekoppelte Ladung $Q_{Takt}$ verringert und das Potential an der Spaltenleitung wird nun nur noch durch die Signalladung bestimmt.

Das Zurückfließen der Ladung kann verhindert werden, wenn zwischen dem Zeilen- und Spaltenkondensator jedes Elementes eine Potentialbarriere erzeugt wird. Gemäß der Erfindung wird diese Potentialbarriere dadurch erzeugt, daß das stärker dotierte Gebiet unter dem einen Kondensator, vorzugsweise dem Zeilenkondensator, sich geringfügig in die unter der anderen Elektrode liegende Halbleiteroberfläche hinein erstreckt. Durch Dotierung, Breite und Tiefe des Gebietes, insbesondere des von der anderen Elektrode (Spaltenelektrode) überlappten Randes kann die gewünschte Potentialbarriere genau eingestellt werden.

Der Bereich, in dem das unter der einen Elektrode befindliche stärker dotierte Gebiet an seinem Rand von der anderen Elektrode überlappt wird, d.h. die Breite, in der das stärker dotierte Gebiet sich unter die andere Elektrode erstreckt, beträgt vorteilhaft 0,3 bis 1,2 $\mu$m, vorzugsweise etwa 0,75 $\mu$m. Im Bereich dieser Überlappung nimmt die Tiefe des stärker dotierten Gebietes vorteilhaft kontinuierlich, vorzugsweise keilförmig, zur anderen Elektrode hin ab. Der Keilwinkel kann dabei zwischen 15 und 60° betragen, bevorzugt werden etwa 20°.

Der Halbleiterkörper kann vorteilhaft aus p-dotiertem Silizium bestehen, für die Elektroden ist insbesondere stark dotiertes Polysilizium geeignet. Bevorzugt wird eine Halbleiterdotierung von $10^{14}$ bis $10^{15}$ cm$^{-3}$ und eine Dotierung des stärker dotierten Gebietes von $10^{16}$ bis $10^{18}$ cm$^{-3}$.

Es wird eine definierte Geometrie des stärker dotierten Bereiches und seiner Laze zu den beiden Sensorelektroden angestrebt. Es ist daher vorteilhaft, wenn die Dotierung des stärker dotierten Gebietes aus Dotierstoff besteht, der mittels einer Implantationsmaske durch Ionenimplantation eingebracht ist, wobei die Kanten der Maskenöffnung zum stärker dotierten Gebiet hin keilförmig abgeschrägt sind. Im Bereich der abgeschrägten Kanten müssen die implantierten Ionen damn zunächst die Implantationsmaske durchdringen, bevor sie in den Halbleiterkörper eindringen können. Die Eindringtiefe der Ionen entspricht daher dem Profil der Maskenöffnung, so daß unterhalb der Maskenöffnungskanten die Begrenzung zwischen der stärker dotierten Gebiet und dem restlichen Halbleiterkörper mit einem definierten Winkel schräg verläuft.

Besonders vorteilhaft ist es, wenn als Maske Schichten verwendet werden, die bei den meisten CID-Sensoren ohnehin vorgesehen sind und aufgebracht werden müssen, nämlich eine das Sensorelement auf der Halbleiteroberfläche umgebende dickere Isolierschicht (Feldoxidschicht) und die zweite Elektrode selbst.

Um einen derartigen Halbleiterkörper herzustellen, kann man demnach auf der Oberfläche eines dotierten Halbleiterkörpers zunächst eine dickere Isolierschicht mit einem von einer dünneren Isolierschicht bedeckten Fenster aufbringen. In diesem Fenster wird sodann auf die dünnere Isolierschicht die in den obigen Ausführungen "zweite Elektrode" genannte Elektrode aufgebracht. Durch das Fenster in der dickeren Isolierschicht kann nun die Ionenimplantation stattfinden. Die Senzorzelle wird schließlich fertiggestellt, indem man die "erste Elektrode" in dem Fenster aufbringt, nachdem man zuvor noch zur elektrischen Isolation der beiden Elektroden die "zweite Elektrode" wenigstens teilweise mit einer dünnen Isolierschicht abgedeckt ist.

Anhand eines Ausführungsbeispieles und 6 Figuren sei die Erfindung näher erläutert.

Fig. 1 zeigt einen Querschnitt durch ein auf einer Halbleiteroberfläche angeordnetes Sensorelement, wobei der Sensor in Zeilen und Spalten angeordnete, durch Zeilen- und Spaltenleitungen miteinander verbundene Sensorzellen enthält und der Schnitt längs einer Zeilenleitung geführt ist.

Fig. 2 zeigt einen Querschnitt durch die gleiche Sensorzelle, der jedoch längs einer Spaltenleitung geführt ist.

Fig. 3 zeigt den Schnitt nach Fig. 1 vor der Fertigstellung des Sensorelementes, nämlich während der Ionenimplantation, d.h. vor dem Aufbringen von Zeilenleitung bzw. Zeilenelektrode.

Die Fig. 4 bis 6 zeigen den Potentialverlauf in der Sensorzelle während des Betriebes.

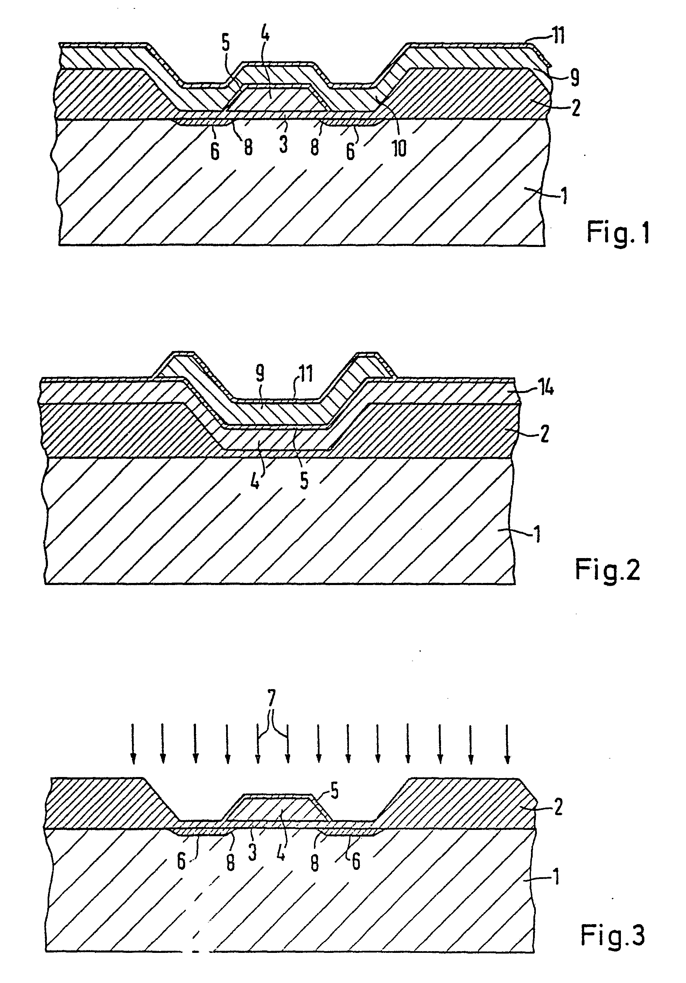

Der optoelektronische Sensor nach der Erfindung wird entsprechend den Fig. 1 bis 3 hergestellt, indem zunächst auf einem Halbleiterkörper 1 (z.B. Silizium mit einer Bor-Dotierung von $5 \times 10^{14}$ cm$^{-3}$) eine relative dicke Isolationsschicht 2, vorzugsweise 600 nm SiO$_2$, aufgebracht wird. In dieser Schicht, die als sog. Feldoxid die einzelnen Sensorelemente voneinander abgrenzen soll, werden Fenster eingeätzt, und anschließend wird in diesen Fenstern (z.B. durch Aufwachsen einer SiO$_2$-Schicht) eine dünne Isolierschicht 3 von z.B. 60 nm Dicke erzeugt. Anschließend wrden die Spaltenelektroden 4 aufgebracht, die einen Teil jeder Fensteröffnung in Feldoxid überdecken und sich als durchgehende Spaltenleitungen 14 über alle Fenster einer Spalte erstrecken. Der Rand dieser Spaltenelektroden nimmit zu den für die Zeilenelektroden vorgesehenen Flächen des Fensters hin keilförmig ab.

Die Herstellung von Schichten aus Isolations- bzw. Elektrodenmaterial, die auf einer Halbleiteroberfläche aufgebracht werden und deren Kanten einen definierten Keilwinkel (Böschungswinkel) aufweisen, ist z.B. in der deutschen Offenlegungsschrift 25 54 638 und in der deutschen Patentanmeldung P 27 23 933 beschrieben.

So kann z.B. auf die Isolierschichten 2 und 3 eine erste Polysiliziumschicht aufgebracht und diese Schicht unter Zuhilfenahme einer Maske außerhalb der für die Spaltenleitungen 14 bzw. Spaltenelektroden 4 vorgesehenen Flächen durch Ionenbeschuß abgesputtert werden. Als Material für die Maske wird ein Stoff verwendet, der beim Absputtern selbst einer Abtragung unterliegt. Dadurch wird die Ätzmaske während des Absputterns angegriffen und ihre Kanten werden abgeschrägt. Das Profil der Ätzmaske wird dadurch in die abzuätzende Schicht übertragen, wobei jedoch die durch das Absputtern in der Isolierschicht erzeugten Vertiefungen nicht senkrecht zur Oberfläche des Halbleiterkörpers verlaufen, sondern einen Keilwinkel bis zu etwa 60° aufweisen. Als Ätzmaske für ein solches Verfahren ist eine Maske aus Fotolack geeignet.

Es können aber die abgeschrägten Kanten auch dadurch erzeugt werden, daß die Polysiliziumschicht zunächst ganzflächig mit Ionen beschossen und anschließend mittels einer Ätzmaske einer naßchemischen oder einer Plasmaätzung ausgesetzt wird. Die dem Ionenstrahl ausgesetzten dünnen Oberflächenbereiche der Schicht weisen eine höhere Abtragungsrate beim Ätzen auf als die dem Ionenstrahl nicht ausgesetzten tieferen Bereiche. Daher werden die von der Ätzmaske geschützten Teile der Schicht vom Maskenrand her mit unterschiedlichen Ätzraten angegriffen und erhalten eine keilartig ansteigenden Rand.

Derartige Verfahren zur Herstellung abgeschrägter Kanten, wie sie z.B. auch im Zusammenhang mit der Herstellung eines MIS-FET mit kurzur Kanallänge auch in der deutschen Patentanmeldung P 27 03 877.3 beschrieben sind, sind gut reproduzierbar.

Anschließend wird eine zweite dünne Isolierschicht 5 in dem Fenster aufgebracht, was vorzugsweise durch Aufwachsen einer zweiten Oxidschicht erfolgt. Sodann wird die Ionenimplantation durchgeführt. Das Aufbringen der zweiten Isolierschicht kann aber auch erst nach der Ionenimplantation erfolgen.

Durch die Ionenimplantation werden unter den von den Spaltenleitungen freigelassenen Flächen in jedem Fenster der Oxidschicht 2 Gebiete 6 erzeugt, die mit dem gleichen Leitunstyp dotiert sind wie das Innere des Halbleiterkörpers 1 selbst. So kann z.B. bei Bor-dotiertem Siliziumhalbleiterkörper Bor mit einer Beschleunigungsenergie von etwa 150 keV entsprechend den Pfeilen 7 implantiert werden. In den neben den Spaltenelektroden 4 liegenden Teilen der Feldoxidöffnungen dringen diese Dotierteilchen durch die dünne Isolierschicht 3 in den Halbleiterkörper ein, während die Beschleunigungsenergie so gewählt ist, daß die Implantationsteilchen in den Spaltenelektroden 4 steckenbleiben. Lediglich im Bereich der abgeflachten Kanten der Spaltenelektroden 4 dringen die Dotierteilchen noch teilweise in den Halbleiterkörper ein, wobei die Eindringtiefe mit zunehmender Dicke der Elektrodenkanten abnimmt. Der Rand 8 des durch die Implantation erzeugten Gebietes 6 erstreckt sich daher noch geringfügig unter die Spaltenelektroden 4, wobei die Eindringtiefe im Bereich der Überlappung jedoch entsprechend dem Anstieg der Elektrodenkanten keilförmig abnimmt.

Der Vorteil dieses Herstellungsverfahrens ist, daß die Geometrie des dotierten Gebietes 6 und ihre Lage zu den Elektroden 4 durch entpsrechende Wahl der Beschleunigungsenergie genau vorgegeben werden kann, ohne daß weitere Lackmasken oder andere zusätzliche Implantationsmasken benötigt würden. Die Herstellung des dotierten Gebietes 6 erfolgt also in einem selbstjustierenden Verfahren, bei dem die ohnehin für die Schaltung benötigten Schichten 2 aus Feldoxid und die Spaltenelektroden 4 selbst als Masken dienen.

In einem weitern Schritt wird sodann eine zweite Lage aus Elektrodenmaterial, z.B. eine zweite Polysiliziumlage 9 aufgebracht, aus der durch entsprechende Ätzung die Zeilenleitungne erzeugt werden, die über die Feldoxidschicht 2 hinweg die Fenster der Feldoxidschicht bedecken und die neben den Spalten-Elektroden 4 liegenden Zeilenelektroden 10 bilden. Anschließend kann der ganze Sensor mit einer Schutzschicht 11 überzogen werden.

Weitere zur Erzeugung eines Sensors nötige Schritte wie die Kontaktierung des Halbleiterkörpers 1 und der Zeilen- und Spaltenleitungen entsprechen dem Stand der Technik, ohne daß sie hier genauer dargestellt und beschrieben zu werden brauchen.

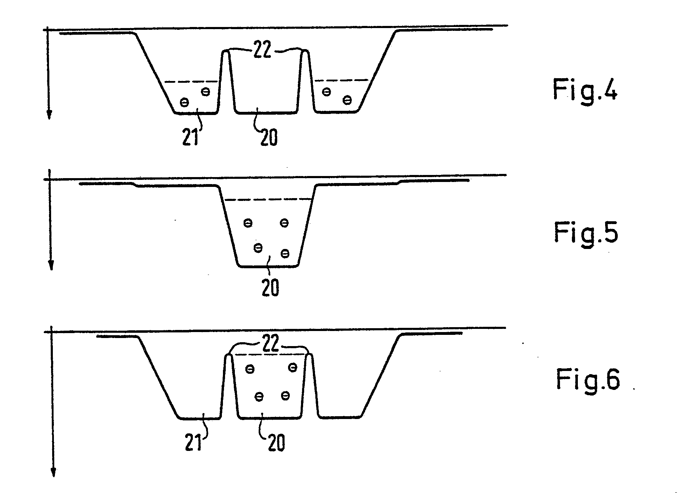

Zum Betrieb des optoelektronischen Sensors werden die (nicht dargestellten) elektrischen Anschlüsse des Halbleiterkörpers 1, der Spaltenleitungen 4 und der Zeilenleitungen 9 derart zueinander gepolt, daß die Majoritätsträger aus dem Substrat abgezogen werden. Bei p-dotiertem Substrat werden also die Elektroden positive gegenüber dem Halbleiterkörper vorgespannt. Es entstehen dadurch unter den Elektroden 4 und 10 Potentialtöpfe 20 und 21, deren Verlauf in Fig. 4 schematisch dargestellt ist. Unter den Kanten 6 der Spaltenelektroden 4 entstehen dabei Potentialschwellen 22, deren Breite und Höhe vom Verlauf der keilförmigen Kanten 6 abhängen. In diesen Potentialtöpfen, besonders in den unter den Zeilenelektroden 10 gebildeten Potentialtöpfen 21, werden nun die Minoritätsträger gesammelt, die durch die Belichtung des Sensors gebildet werden.

Werden nun die Spaltenleitungen 14 frei schwebend gelassen und die Vorspannung der Zeilenleitungen gegenüber dem Substrat derart verringert, daß das Potential in den Potentialtöpfen 21 über die Potentialschwelle 22 angehoben wird, so werden alle Ladungsträger in den Potentialtopf 20 verschoben (Fig. 5). Anschließend wird die ursprüngliche Polarität der Zeilenleitungen 9 gegenüber dem Halbleiterkörper 1 wieder hergestellt, wobei jedoch nunmehr die im Potentialtopf 20 gesammelte Ladung nicht über den Potentialwall 22 zurückfließen kann (Fig. 6). Ein bei der Anhebung des Zeilenpotentials in die Spaltenleitungen fließender Verschiebestrom wird bei der Rücksetzung des Zeilenpotentials dabei aus den Spaltenleitungen zurückfließen und beeinträchtigt nicht das an den floatenden Spaltenleitungen anliegende Signal, das dort als Meßsignal entnommen werden kann.

Durch Anhebung der Potentiale der Zeilenleitungen und Spaltenleitungen wird schließlich die im Potentialtopf 20 gesammelte Ladung ins Substrat entleert und der Ausgangszustand des Sensors für den nächsten Takt zur Sammlung der optisch erzeugten Ladungen hergestellt.

Das hier anhand eines Sensors mit reihenweise und zeilenweise angesteuerten Elektroden auf p-dotiertem Substrat geschilderte Ausführungsbeispiel kann natürlich auch auf andere Dotierungen und andere Anordungen von kapazitiv gekoppelten MIS-Kondensator-Paaren übertragen werden.

**Patentansprüche**

1. Optoelektronischer Sensor mit mindestens einem Sensorelement nach dem Prinip der Ladungsinjektion (CID), das zwei der Oberfläche eines dotierten Halbleiterkörpers (1) eng benachbarte, gegeneinander und gegenüber der Halbleiteroberfläche durch eine dünne Isolierschicht (3, 5) isolierte, über getrennte Steuerleitungen ansteuerbare Elektroden aufweise, wobei die mit der ersten Elektrode (4) verbundene Steuerleitung (14) als Ausleseleitung dient und die mit der zweiten Elektrode (10) verbundene Steuerleitung zur Verschiebung der unter der zweiten Elektrode (10) optisch erzeugten Ladungsträger unter die erste Elektrode (4) dient, dadurch gekennzeichnet, daß der Halbleiterkörper (1) an seiner Oberfläche unter der zweiten Elektrode (10) ein stärker dotiertes Gebiet (6) vom Typ der Halbleiterdotierung enthält, das sich geringfügig in die unter der ersten Elektrode (4) liegende Halbleiteroberfläche hinein erstreckt.

2. Optoelektronischer Sensor nach Anspruch 1, dadurch gekennzeichnet, daß sich das stärker dotierte Gebiet 0,3 bis 1,2 $\mu m$, vorzugsweise etwa 0,75 $\mu m$, unter die eiste Elektrode erstreckt.

3. Optoelektronischer Sensor nach Anspruch 2, dadurch gekennzeichnet, daß die Tiefe des stärker dotierten Gebietes zur ersten Elektrode hin unterhalb dieser ersten Elektrode kontinuierlich, vorzugsweise keilförmig, abnimmt.

4. Optoelektronischer Sensor nach Anspruch 3, dadurch gekennzeichnet, daß der Keilweinkel zwischen 15° und 60°, insbesondere etwa 20°, beträgt.

5. Optoelektronischer Sensor nach einem der Ansprüche 1 bis 4, dadurch gekennzeichnet, daß der Halbleiterkörper aus p-dotiertem Silizium besteht.

6. Optoelektronischer Sensor nach einem der Ansprüche 1 bis 5, dadurch gekennzeichnet, daß die Halbleiterdotierung $10^{14}$ bis $10^{15}$ cm$^{-3}$ und die stärkere Dotierung $10^{16}$ bis $19^{18}$ cm$^{-3}$ beträgt.

7. Optoelektronischer Sensor nach einem der Ansprüche 1 bis 6, dadurch gekennzeichnet, daß das stärker dotierte Gebiet durch Ionenimplantation (7) mittels einer Implantationsmaske (2, 4) eingebrachte Dotierteilchen enthält, deren Maskenöffnungskanten zum stärker dotierten Gebiet hin keilförmig abgeschrägt ist.

8. Optoelektronischer Sensor nach Anspruch 7, dadurch gekennzeichnet, daß die Maske aus einer sas Sensorelement auf der Halbleiteroberfläche umgebenden dickeren Isolierschicht (2) und der ersten Elektrode (4) besteht.

9. Verfahren zur Herstellung eines optoelektronischen Sensors nach einem der Ansprüche 1 bis 8, dadurch gekennzeichnet, daß auf die Oberfläche eines dotierten Halbleiterkörpers (1) eine dickere Isolierschicht (2) mit einem von einer dünneren Isolierschicht (3) bedeckten Fenster aufgebracht wird, daß auf diese dünnere Isolierschicht eine das Fenster teilweise ausfüllende erste Elektrode (4) mit einer keilförmig abfallenden Kante aufgebracht wird, daß anschließend Dotierteilchen (7) mit einer derartigen Energie durch das Fenster der dickeren Isolierschicht in den Halbleiterkörper implantiert werden, daß unter der vond er ersten Elektrode (4) nicht bedeckten Teilfläche des Fensters ein stärker dotiertes Gebiet (6) entsteht, dessen Begrenzung (8) zum restlichen Halbleiterkörper unter den kilförmigen Kanten der ersten Elektrode an die Oberfläche heranreicht, und daß schließlich in dem Fenster neben der ersten Elektrode eine von der ersten Elektrode (4) durch eine zweite dünne Isolierschicht (5) isolierte zweite Elektrode (10) aufgebracht wird.

**Revendications**

1. Détecteur opto-électronique qui comporte au moins un élément détecteur qui fonctionne suivant le principe d'injection de charges (CID), et comporte deux électrodes, qui peuvent être commandées par l'intermédiaire de conducteurs de commande distincts, sont très proches de la surface d'un corps semiconducteur dopé (1) et sont isolées l'une de l'autre et vis-à-vis de la surface du corps semiconducteur par une mince couche isolante (3, 5), le conducteur de commande (14) relié à la première électrode (4) servant de conducteur de lecture et le conducteur de commande relié à la seconde électrode (10) servant à décaler, sous la première électrode (4), les porteurs de charge qui sont produits optiquement sous la seconde électrode (10), caractérisé par le fait que le corps semiconducteur (1) comporte sur sa surface, sous la seconde électrode (10), une zone plus fortement dopée (6), possédant le même type de dopage, qui s'étend légèrement dans la surface du corps semiconducteur qui se trouve sous la première électrode (4).

2. Détecteur opto-électronique suivant la revendication 1, caractérisé par le fait que la zone plus fortement dopée s'étend sur une distance de 0,3 à 1,2 $\mu$m, de préférence environ 0,75 $\mu$m, sous la première électrode.

3. Détecteur opto-électronique suivant la revendication 2, caractérisé par le fait que la profondeur de la zone la plus fortement dopée diminue de façon continue, de préférence de façon cunéiforme, en direction de la première électrode, sous cette première électrode.

4. Détecteur opto-électronique suivant la revendication 3, caractérisé par le fait que l'ange d'inclinaison est compris entre 15° et 60°, et est notamment égal à 20°.

5. Détecteur opto-électronique suivant l'une des revendications 1 à 4, caractérisé par le fait que le corps semiconducteur est constitué par du silicium de dopage p.

6. Détecteur opto-électronique suivant l'une des revendications 1 à 5, caractérisé par le fait que le dopage du semiconducteur est compris entre $10^{14}$ et $10^{15}$ cm$^{-3}$ et que le dopage plus fort est compris entre $10^{16}$ et $10^{18}$ cm$^{-3}$.

7. Détecteur opto-électronique suivant l'une des revendications 1 à 6, caractérisé par le fait que la zone plus fortement dopée contient des particules de dopage introduites par implantation d'ions (7), au moyen d'un masque d'implantation (2, 4), dont les bords de l'ouverture sont chanfreinés en forme de coins en direction de la zone plus fortement dopée.

8. Détecteur opto-électronique suivant la revendication 7, caractérisé par le fait que le masque est constitué par une couche isolante plus épaisse (2) qui entoure l'élément détecteur sur la surface du corps semiconducteur, et par la première électrode (4).

9. Procédé pour fabriquer un détecteur opto-électronique suivant l'une des revendications 1 à 8, caractérisé par le fait que sur la surface d'un corps semconducteur dopé (1) on dépose une couche isolante plus épaisse (2) comportant une fenêtre recouverte par une couche isolante plus mince (3), que sur cette couche isolante plus mince on dépose une première électrode (4), remplissant partiellement la fenêtre, qui possède un bord qui descend en forme de coin, qu'ensuite des parties de dopage (7) sont implantées dans le corps semiconducteur, à travers la fenêtre de la couche isolante plus épaisse, avec une énergie telle qu'il apparaît, sous la surface partielle de la fenêtre qui n'est par recouverte par la première électrode (4), une zone plus fortement dopée (6) dont la délimitation (8) par rapport au corps semiconducteur restant arrive à la surface sous les bords en forme de coins de la première électrode, et qu'enfin on dépose dans la fenêtre, à côté de la première électrode, une seconde électrode (10) isolée de la première électrode (4) par une secnde couche isolante mince (5).

## Claims

1. An opto-electronic sensor comprising at least one sensor element in accordance with the charge-injection principle (CID), which element possesses two electrodes closely adjacent to the surface of a doped semiconductor body (1), which are insulated from one another and from the semiconductor surface by a thin insulating layer (3, 5), and which can be controlled by means of separate control lines, the control line (14) connected to the first electrode (4) serving as a read-out line and the control line connected to the second electrode (10) serving to shift the charge carriers, which are optically produced below the second electrode (10), beneath the first electrode (4), characterised in that at its surface below the second electrode (10), the semiconductor body (1) contains a highly doped region (6) of the semiconductor doping type, which region extends only to a negligible extent into the semiconductor surface below the first electrode (4).

2. An opto-electronic sensor according to Claim 1, characterized in that the highly doped region extends 0.3 to 1.2 $\mu$m, preferably approximately 0.75 $\mu$m, below the first electrode.

3. An opto-electronic sensor according to Claim 2, characterised in that the depth of the highly doped region decreases continuously in the direction of the first electrode below this electrode, preferably in a wedge-shaped manner.

4. An opto-electronic sensor according to Claim 3, characterised in that the wedge angle is in the range between 15° and 60°, in particular about 20°.

5. An opto-electronic sensor according to one of Claims 1 to 4, characterised in that the semiconductor body consists of p-doped silicon.

6. An opto-electronic sensor according to one of Claims 1 to 5, characterised in that the semiconductor doping is $10^{14}$ to $10^{15}$ cm$^{-3}$, and the higher doping is $10^{16}$ to $19^{18}$ cm$^{-3}$.

7. An opto-electronic sensor according to one of Claims 1 to 6, characterised in that the highly doped region contains doping particles which are introduced by ion implantation (7) using an implantation mask (2, 4) the edges of the mask openings of which are chamfered in wedge-shaped fashion towards the highly doped region.

8. An opto-electronic sensor according to Claim 7, characterised in that the mask consists of a thick insulating layer (2), which surrounds the sensor element on the semiconductor surface, and the first electrode (4).

9. A process for the production of an opto-electronic sensor according to one of Claims 1 to 8, characterised in that a thick insulating layer (2) having a window covered by a thin insulating layer (3) is applied to the surface of a doped semiconductor body (1); that a first electrode (4) which partially fills the window and has an edge which slopes in wedge-shaped fashion, is applied to the thin insulating layer; that doping particles (7) are subsequently implanted through the window in the thick insulating layer into the semiconductor body with such an energy that a highly doped region (6) is produced below the part of the surface of the window which is not covered by the first electrode (4), the boundary (8) of which region (6) with the remaining semiconductor body extends below the wedge-shaped edges of the first electrode to the surface; and that finally, in the window beside the first electrode, a second electrode (10), which is insulated from the first electrode (14) by a second thin insulating layer (5), is applied.

Fig. 1

Fig. 2

Fig. 3

Fig.4

Fig.5

Fig.6